# EUROPEAN PATENT APPLICATION

(11) **EP 2 605 283 A2**
(43) Date of publication of application: **19.06.2013**
(21) Application number: 12193675.1
(22) Date of filing: 21.11.2012
(51) Int. Cl.: H01L 29/778, H01L 21/336, H01L 29/51, H01L 29/423, H01L 29/20

(54) **In situ grown gate dielectric and field plate dielectric**

(30) Priority: 12.12.2011 US 201113323672
(71) Applicant: Power Integrations, Inc., San Jose, California 95138 (US)
(72) Inventor: Edwards, John Paul, Verona, NJ New Jersey 07044 (US); Liu, Linlin, Hillsborough, NJ New Jersey 08844 (US)
(74) Representative: Schley, Jan Malte

(57) **Abstract**

Methods and apparatuses are disclosed for providing heterostructure field effect transistors (HFETs) with high-quality gate dielectric and field plate dielectric. The gate dielectric and field plate dielectric are in situ deposited on a semiconductor surface. The location of the gate electrode may be defined by etching a first pattern in the field plate dielectric and using the gate dielectric as an etch-stop. Alternatively, an additional etch-stop layer may be in situ deposited between the gate dielectric and the field plate dielectric. After etching the first pattern, a conductive material may be deposited and patterned to define the gate electrode. Source and drain electrodes that electrically contact the semiconductor surface are formed on opposite sides of the gate electrode.

## Description

### BACKGROUND

### 1. Field

The present disclosure relates generally to high-voltage field effect transistors (FETs), and, more specifically, the present disclosure relates to improved fabrication processes for manufacturing high-voltage FETs.

### 2. Background

Many electrical devices such as cell phones, personal digital assistants (PDAs), laptops, etc. utilize power to operate. Because power is generally delivered through a wall socket as high voltage alternating current (AC), a device, typically referred to as a power converter can be utilized to transform the high-voltage AC input to a well regulated direct current (DC) output through an energy transfer element. Switched mode power converters are commonly used to improve efficiency, size, and reduce component count in many of today's electronics. A switch mode power converter may use a power switch that switches between a closed position (ON state) and an open position (OFF state) to transfer energy from an input to an output of the power converter. Typically, power switches are high-voltage devices required to withstand voltages substantially greater than the AC input voltage.

One type of high-voltage FET is the heterostructure FET (HFET), also referred to as a high-electron mobility transistor (HEMT). HFETs may be used as switches in switching devices for high-voltage power electronics, such as power converters. In certain applications, HFETs based on wide bandgap semiconductors may be useful because the higher bandgap may improve performance at elevated temperatures. Examples of wide bandgap semiconductors used in high-voltage HFETs include materials such as silicon carbide (SiC), gallium nitride (GaN), and diamond, although other materials may be used as well.

### BRIEF DESCRIPTION OF THE FIGURES

Various aspects, features, and advantages of several embodiments of the present invention will be more apparent from the following more particular description thereof, presented in conjunction with the following drawings.

Non-limiting and non-exhaustive embodiments of the present invention are described with reference to the following Figures, wherein like reference numerals refer to like parts throughout the various views unless otherwise specified.

FIG. 1 illustrates an example HFET including a gate electrode separated from a gate field plate in accordance with an embodiment of the present invention.

FIG. 2 illustrates a flow chart of an example process for fabricating an example HFET in accordance with an embodiment of the present invention.

FIG. 3 illustrates an example HFET at a stage during the example process according to an embodiment of the present invention.

FIG. 4 illustrates an example HFET at another stage during the example process according to an embodiment of the present invention.

FIG. 5 illustrates an example HFET at yet another stage during the example process according to an embodiment of the present invention.

FIG. 6 illustrates an example HFET at still another stage during the example process according to an embodiment of the present invention.

FIG. 7 illustrates an example HFET fabricated with the example process according to an embodiment of the present invention.

FIG. 8 illustrates an example HFET fabricated with another example that includes a stop etch layer according to an embodiment of the present invention.

FIG. 9 illustrates an example HFET fabricated with an example process that includes a gate electrode with substantially vertical side walls according to an embodiment of the present invention.

FIG. 10 illustrates an example HFET fabricated with an example process according to an embodiment of the present invention.

### DETAILED DESCRIPTION

In the following description, numerous specific details are set forth in order to provide a thorough understanding of the present invention. It will be apparent, however, to one having ordinary skill in the art that the specific detail need not be employed to practice the present invention. In other instances, well-known materials or methods have not been described in detail in order to avoid obscuring the present invention.

Reference throughout this specification to "one embodiment," "an embodiment," "one example," or "an example" means that a particular feature, structure or characteristic described in connection with the embodiment or example is included in at least one embodiment of the present invention. Thus, appearances of the phrases "in one embodiment," "in an embodiment," "one example," or "an example" in various places throughout this specification are not necessarily all referring to the same embodiment or example. Furthermore, the particular features, structures, or characteristics may be combined in any suitable combinations and/or subcombinations in one or more embodiments or examples. Particular features, structures, or characteristics may be included in an integrated circuit, an electronic circuit, a combinational logic circuit, or other suitable components that provide the described functionality. In addition, it is appreciated that the Figures provided herewith are for explanation purposes to persons ordinarily skilled in the art and that the drawings are not necessarily drawn to scale.

In the description below, an example FET is used for the purposes of explanation. The example FET is referred to as an HFET despite the FET having a gate dielectric. In this respect, the example FET could also be called a metal insulator semiconductor FET (MISFET). For ease of explanation, however, the term HFET is used. It should be understood that use of this term is not limiting on the claims.

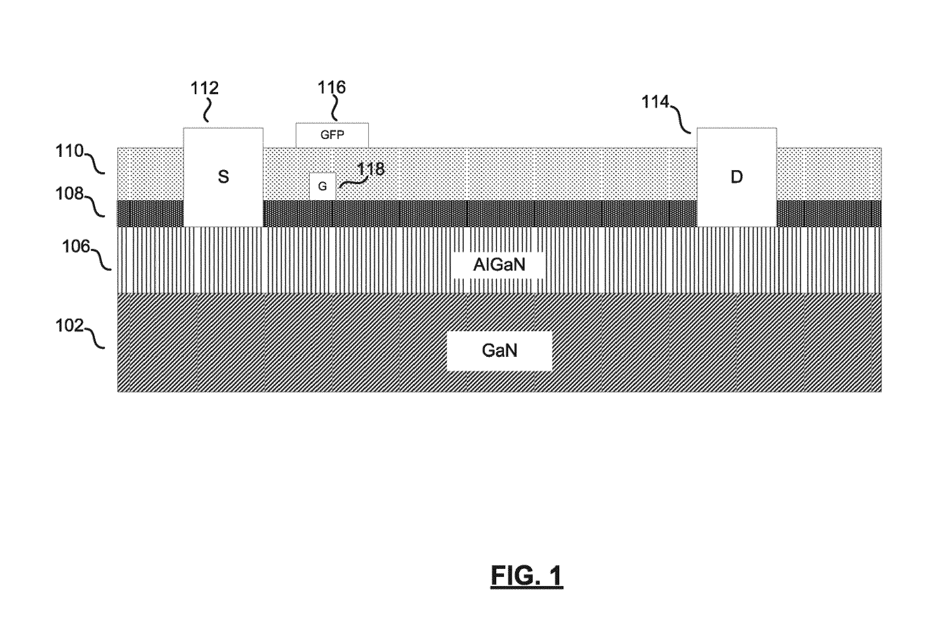

FIG. 1 illustrates an aluminum gallium nitride (AlGaN)/GaN HFET. The HFET includes a GaN film 102 that may be a top layer (e.g., grown or deposited) on a handle substrate, such as a silicon, silicon carbide, single crystal GaN, or sapphire substrate (not shown). As further shown, an AlGaN film 106 is deposited over GaN film 102. AlGaN film 102 forms a barrier layer. In other cases, a thin film, for example 10 to 20A, of GaN may be deposited as a surface capping layer (not shown) on top of AlGaN film 106. In one example, a sheet of 2 dimensional electron gas (2DEG) is formed at the hetero-interface of AlGaN and GaN due to a piezoelectric effect on the lattice of the GaN. The high concentration of highly mobile electrons in the electron plasma (electron gas) located near the top surface of GaN film 102 allows for a low resistance path between a source electrode 112 and a drain electrode 114, which enables operation at high frequencies. In another example, both source and drain electrodes may be alloyed through the AlGaN film at a high temperature and physically contact the 2DEG at the hetero-interface.

As shown, a gate electrode 118 above a gate dielectric layer 108 controls the current conduction path between source electrode 112 and drain electrode 114. Gate dielectric layer 108 may also act as a passivation layer for the surface of AlGaN film 106. Specifically, gate dielectric layer 108 functions as a passivation layer for the "un-gated" region (i.e., the region between the edge of the gate and the source and the region between the other edge of the gate and the drain). Gate field plate (GFP) 116, formed on top of field plate dielectric 110, may alleviate the electric field intensity at an edge (closest to the drain) of gate electrode 118 and may also reduce leakage current by controlling the states of charge traps at the interface between AlGaN film 106 and gate dielectric layer 108.

In addition to leakage current, examples of other potential concerns for HFET design are current collapse and gate dielectric breakdown. Current collapse, which is the unintended reduction of drain current during operation or in a stressed state, may be caused by charge trapping at the surface of the AlGaN film or elsewhere in the AlGaN and GaN layers. In addition to improving the passivation of the surface of the AlGaN film, a field plate may also be used to reduce current collapse.

Gate dielectric breakdown is the electrical shorting of the gate electrode to the AlGaN/GaN films and results from a dfective or over-stressed gate dielectric. Higher quality gate dielectrics may improve an HFET's breakdown performance and long-term reliability.

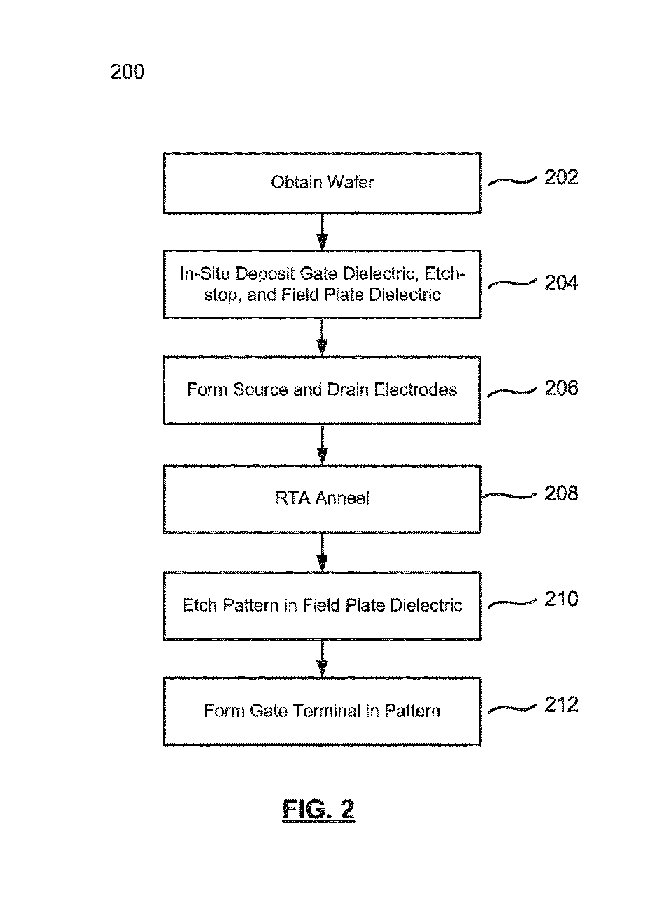

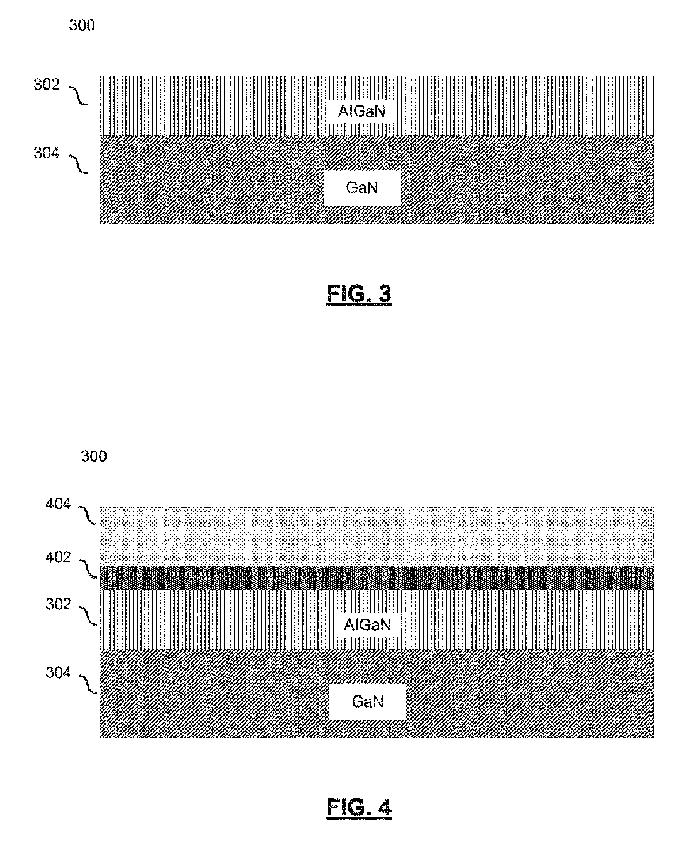

FIG. 2 illustrates flow chart 200 describing an example process for fabricating an HFET. The example process is also described with respect to FIGS. 3-7, which depict an example HFET at various stages during a fabrication process that employs the example process. It should be recognized that the operations and steps below may not be a complete listing of all operations and steps necessary to fabricate an HFET. For example, conventional cleaning operations may be required to prep the wafer surface prior to deposition steps. The example process is described with respect to fabricating an AlGaN/GaN HFET. However, this HFET is being used for explanation purposes. It should be understood that other example processes may be used with other materials and for other types of FETs without deviating from the present invention.

In block 202, as illustrated in FIG. 3, a wafer 300 is obtained. The wafer may be made of a suitable material, such as, silicon (Si), sapphire (Al₂O₃), or silicon carbide (SiC). However, other materials may also be used. Wafer 300 may also have active semiconductor films grown or deposited on a surface of wafer 300. For example, in the current example process, wafer 300 has an AlGaN film 302 on top of a GaN film 304. The two films, AlGaN film 302 and GaN film 304, form an active layer, meaning that during device operation, conduction may occur in or near these two films. Other wafers with additional or fewer films may also be used. Other semiconductor materials may also be used. For example, materials such as AlN, InAlN, InGaN, GaAs, InP, or SiC may also be used.

AlGaN film 302, which is used as a barrier film, may be 10 to 40nm thick. GaN film 304, which forms the channel film, may be about 0.3 to 5µm thick. However, other thicknesses may also be used.

FIG. 3 illustrates an example of wafer 300 obtained in block 202 (FIG. 2). Wafer 300 includes an AlGaN film 302 on GaN film 304. In some cases, GaN film 304 is on a handle wafer (not shown) made of another material, such as Si, Al₂O₃, SiC, GaN, or the like. AlGaN film 302 and GaN film 304 may be grown on the handle wafer or a completed wafer 300 may be purchased from a vendor. GaN film 304 could also be a top thickness of a thicker GaN wafer.

In block 204, as illustrated in FIG. 4, at least two films are in situ deposited using an atomic layer deposition (ALD) tool. The term "in situ," may be defined as a process that is carried out in a single tool without exposing the wafer to the environment outside the tool. For example, in situ depositing two films on a wafer in an ALD tool means depositing the two films on a wafer in an ALD tool without exposing the wafer to the environment outside the tool between the depositions of the two films.

Referring to FIG. 4, a first film 402 deposited in the ALD tool may be a dielectric material that forms the gate dielectric for the HFET. This film may be made of materials such as Al₂O₃, zirconium dioxide (ZrO₂), aluminum nitride (AlN), hafnium oxide (HfO₂), or other suitable gate dielectric materials. The thickness may be, for example, from 5nm-20nm.

In one example, first film 402 may also function as a passivation layer that forms a high quality interface with AlGaN film 302. The quality of the passivation layer may affect the quality of the interface with AlGaN film 302, which may affect the onset of current collapse due to carrier traps and trapped charge at the interface.

A second film 404 deposited in the ALD tool may be a dielectric material that is deposited directly onto first film 402 and serves as a field plate dielectric film for separating a field plate from the gate dielectric and AlGaN film 302. In some cases, the material of the second film may be selected to have a specific electrical property. For example, the material for second film 404 may depend on properties such as permittivity, refractive index, defect density, stability, and mechanical stress. In other cases, the material of the second film may be selected for integration or fabrication reasons. For example, the material for second film 404 may depend on the material and thickness of first film 402 so that second film 404 may be properly etched while maintaining the integrity of first film 402. In one example, second film 404 may be selected to have sufficiently different etch properties from first film 402 so that first film 402 may be used as an etch-stop when etching second film 404. Specifically, second film 404 may be chosen so that the etch selectivity ratio between first film 402 and second film 404 may be at least 5. Etch selectivity is the ratio of etch rate of a first material to the etch rate of a second material. For example, an etch selectivity of 10 to a first material over a second material means that the amount (e.g., thickness) of etched first material is about 10 times greater than the amount (e.g., thickness) of etched second material. Importantly, while being used as an etch-stop layer, first film 402 should not be completely removed to expose the active semiconductor layer below. Rather, the amount of additional etching into first film 402 that may occur when etching the second film may be minimized to maintain a high-quality gate dielectric (i.e., first film 404). In one example, the thickness of second film 404 may be 80 nm to 200 nm and may be made from, for example, silicon nitride (SiN), Al₂O₃, silicon dioxide (SiO₂), or other suitable materials.

Using ALD techniques, a film thickness may be deposited one layer at a time on a substrate surface, each layer being a fraction of the total film thickness. In one example, each cycle of deposition may be no thicker than one atomic layer due to the self-limiting ALD process. In this example, each cycle of deposition is typically less than one atomic layer because complete coverage is never obtained with each cycle. Deposition of the full desired film thickness is carried out over many cycles of the same sequence of steps. For example, one cycle may include the sequences of: (1) a chemi-sorbtion or chemical dose step, (2) a chemical dose purge, (3) a plasma step, and (4) a post plasma purge. The chemical dose step deposits a thin layer of chemical over a substrate surface. The chemical may, for example, be a precursor necessary to create a layer of the desired film material. A purge step is then performed to remove any remnants of the chemical in the chamber. Next, a plasma step may cause a gas plasma to react with the chemical precursor on the substrate surface, or may include multiple gas plasmas that react with each other on a substrate surface, to create a thin layer of the desired material on the substrate surface. Finally, another purge step is performed to remove remnants of the plasma gas from the chamber. This cycle of steps may be repeated as many times as necessary to obtain the desired thickness of film. One example of an ALD tool for carrying out this type of process is an Oxford ALD FlexAl System. While an example ALD cycle has been explained above with respect to four steps, other ALD cycles with additional, fewer, or different steps may be contemplated.

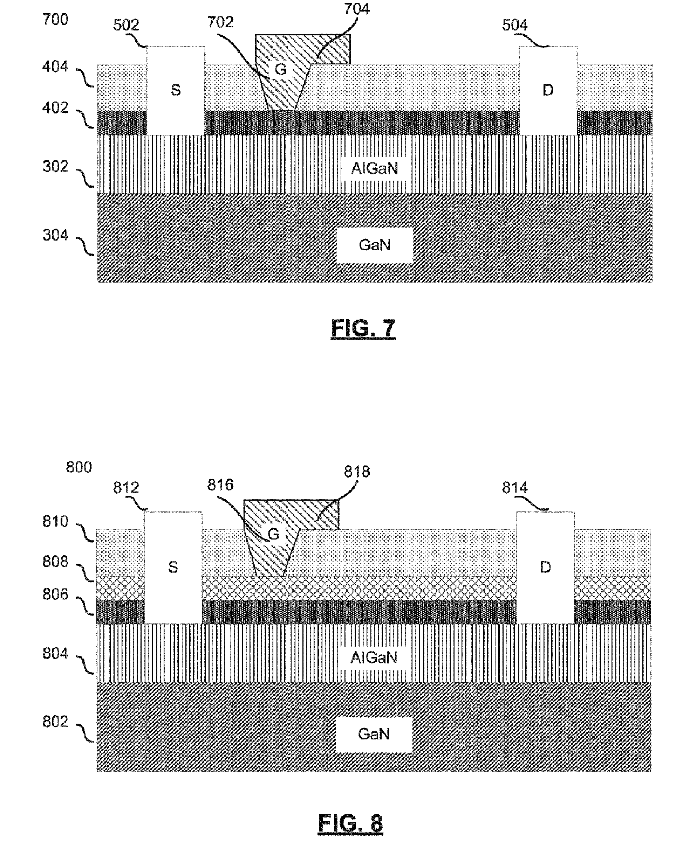

As explained in more detail below with respect to FIG. 8, a third film may also be deposited between the first and second films (i.e., after first film 402 but before the second film 404). The third film may be used as an etch-stop film so that the first and second films may be the same material or have similar etch properties.

In this example, the first and second films are in situ deposited on the wafer in the ALD tool, i.e., without exposing the wafer to the environment outside the tool between the deposition of the two films. Because the films are deposited sequentially without removal from the tool, the wafer is protected from contamination that may degrade the quality of the films or the AlGaN surface. In addition, because the wafer is not removed between depositions of films, the processing throughput of the tool may be increased. In particular, by not removing the wafers between depositions, wafer handling times (e.g., pumping the load lock down to the appropriate vacuum levels, moving wafers from tool to tool, etc.) may be decreased. Thus, the deposition capabilities of the ALD tool may be utilized at a higher rate.

Other potential benefits of using an ALD tool include low temperature processing, moving plasma away from the surface of the wafer (i.e., "remote plasma"), which may help maintain the integrity of the wafer surface, creating ultra high quality films, and depositing in high-aspect ratio holes.

In one example of an ALD process recipe, an Al₂O₃ film may be deposited in an ALD chamber at 300°C with a growth rate of about 1.4A/cycle. Each cycle of the deposition starts with a chemical dose of about 20ms at 15mT. In one case, trimethylaluminum (TMA) is used. Next the chamber is purged with 50cc of nitrogen (N₂) and 100cc argon (Ar) for 1.5s, which removes the residue of the chemical vapor from the chamber. Next a 2s 50cc oxygen (O₂) plasma dose step is performed with a plasma power of 400W. Next, the chamber is purged again for 1s with 50cc of N₂ and 100cc Ar to remove the residue of the gas plasma from the chamber. The cycle may then be repeated as many times as necessary to obtain the desired film thickness. For example, a total of 100 cycles would produce a film of approximately 150A.

In another example of an ALD process recipe, an HfO₂ film may be deposited in an ALD chamber at 300°C with a growth rate of about 1.2A/cycle. Each cycle of the deposition starts with a chemical dose of about 1.1s at 80mT. In one case, tetrakis-(ethylmethylamino)-hafnium (TEMAH) is used with a 200cc Ar flow through a bubbler. Next the chamber is purged with 100cc of N₂ and 250cc Ar for 13s, which removes the residue of the chemical vapor from the chamber. Next a 4s 50cc O₂ dose plasma treatment step is performed with a plasma power of 250W at 15mT. Then the chamber is purged again for 2s with 100cc of N₂ and 250cc Ar at 80mT to remove the residue of the gas plasma from the chamber. The cycle may then be repeated as many times as necessary to obtain the desired film thickness. For example, a total of 17 cycles would produce a film of approximately 20A.

In yet another example of an ALD process recipe, an AlN film may be deposited in an ALD chamber at 300°C with a growth rate of about 0.7A/cycle. Each cycle of the deposition starts with a chemical dose of about 30ms at 15mT. In one case, TMA is used. Next the chamber is purged with 100cc of N₂ and 100cc Ar for 2s, which removes the residue of the chemical vapor from the chamber. Next a 15s 30cc N₂ plasma treatment step is performed with a plasma power of 400W at 10mT. Then the chamber is purged again for 3s with 100cc of N₂ and 100cc Ar at 15mT to remove the residue of the gas plasma from the chamber. The cycle may then be repeated as many times as necessary to obtain the desired film thickness. For example, a total of 29 cycles would produce a film of approximately 20A.

These procedures are examples and other variations may be developed that do not take away from the spirit of the invention. For example, an SiN recipe may be developed using similar steps as above with tris[dimethylamino]silane (3DMAS) or bis[tertiary-butylamino]silane (BTBAS) gas being used for the chemical dose and N₂, H₂, or NH₃ for the plasma gas.

FIG. 4 illustrates wafer 300 after deposition of first film 402 and second film 404. In this embodiment, first film 402 is 150A of Al₂O₃ and second film 404 is 1500A of SiN.

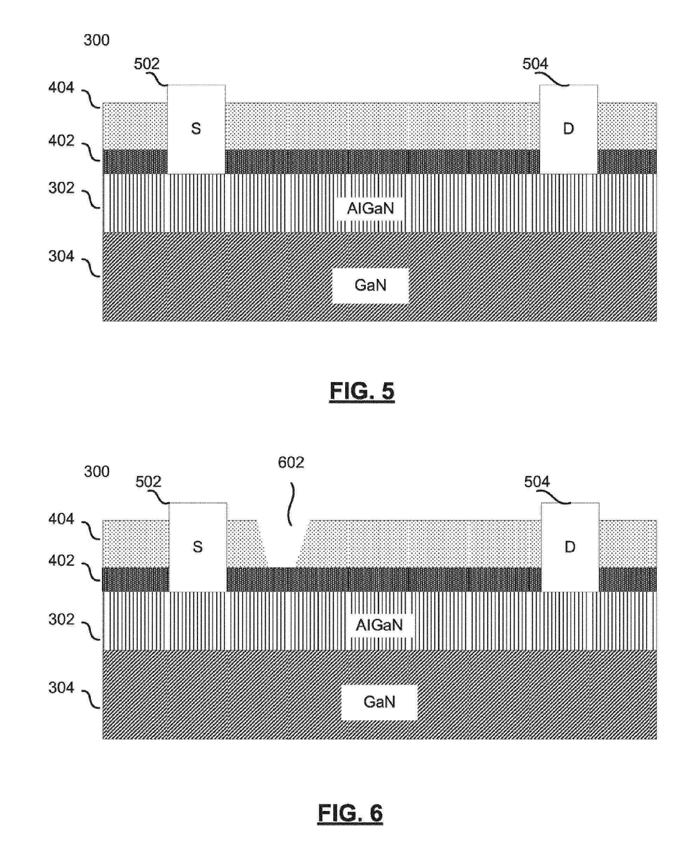

In block 206, as illustrated in FIG. 5, a source electrode 502 and a drain electrode 504 are formed. These electrodes electrically contact AlGaN film 302 and GaN film 304. Block 206 may include, for example, depositions of insulating layers, a lithographic step to etch holes in insulating and/or other films, a metal deposition, and another lithographic step to pattern the metal. The metal stack for the source and drain electrodes may include, for example, TiAlMoAu, TiAlNiAu, or TiAlPtAu. Other conductive materials besides metals may also be used.

FIG. 5 depicts source electrode 502 and drain electrode 504 as being in physical contact with AlGaN film 302. In other examples, source electrode 502 and drain electrode 504 may also be in physical contact with GaN film 304.

In block 208, a rapid thermal anneal (RTA) step is performed, for example, to ensure an ohmic contact between the source and drain electrodes and the AlGaN or GaN films. In one example, the temperature range for an RTA process may be between 500°C to 850°C depending on the specific metal stack, surface pre-treatment, and whether the electrodes are formed in a recessed hole that reaches the GaN film. The temperature ramp rate may be about 10 to 15 °C/min, and the soak time at the peak temperature may be about 30s to 1 min.

In block 210, as illustrated in FIG. 6, a pattern is etched in second film 404 to define a location for the gate electrode. A lithographic process may be used for this block. For example, the pattern may be defined using a mask to create a photoresist pattern on second film 404 that may then be etched using a selective etch that preferentially etches the material of second film 404 at a faster rate as compared to the etch rate for the material of first film 402. This pattern defines an eyelet 602 that defines the location of a gate electrode without contacting the AlGaN film and while maintaining the integrity of gate dielectric film (i.e., first film 402). As discussed below with respect to FIG. 8, an additional film between first film 402 and second film 404 may be used as an etch-stop film while etching first film 402 to enable the use of materials with similar etch properties for first film 402 and second film 404.

FIG. 6 illustrates wafer 300 after a pattern is defined in second film 404. The pattern includes eyelet 602, which defines the location of the gate electrode. Note that eyelet 602 stops at first film 402 because of the etch property difference between second film 404 and first film 402. In other words, the etch used to form eyelet 602 is selective to first film 402 over second film 404. As shown in FIG. 6, eyelet 602 extends to the top surface of first film 402 as originally deposited. In other examples, eyelet 602 may continue into first film 402 by some distance that is less than the thickness of first film 402.

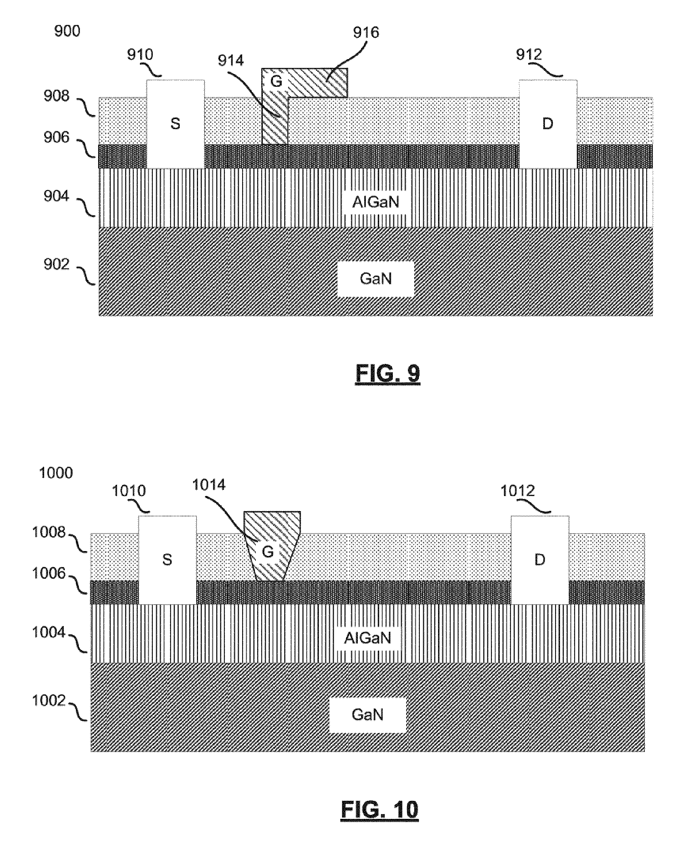

The sloped side walls of eyelet 602 may reduce the peak electrical field at the edge of the gate electrode towards the drain side. Minimizing the electrical field density along certain surfaces of the gate electrode may increase breakdown voltage and reduce current collapse by preventing the injection of hot carriers into the gate dielectric and passivation layer (i.e., first film 402). However, as described below with respect to FIG. 9, other shapes of the gate electrode may also be used by modifying the steps of the lithographic process used to form eyelet 602 (e.g., modifying the photoresist and exposure process or the etch process).

In block 212, as illustrated in FIG. 7, a gate electrode 702 is formed in the pattern defined in block 206. Optionally, a gate field plate 704 may also be formed over second film 404 using the same conductive material that is used for the gate material. Gate electrode 702 and, optionally, gate field plate 704 may be formed using a conductor deposition step and a lithographic patterning step. In one example, gate electrode 702 and gate field plate 704 are formed together.

FIG. 7 illustrates example HFET 700 manufactured with the example process discussed above with respect to flow chart 200 of FIG. 2. In particular, FIG. 7 illustrates wafer 300 after deposition and patterning of a conductive film, for example, Al, Ni, Ti, TiW, TiN, or doped polysilicon, over wafer 300. The conductive film now defines gate electrode 702 and gate field plate 704 (optional), which is adjacent and connected to gate electrode 702. Gate field plate 704 may help reduce current collapse by minimizing or suppressing charge trapping effects at the AlGaN/first film interface. While FIG. 7 illustrates one particular configuration of gate field plate 704, it should be understood that other configurations of gate field plates may also be used.

While the example process of flow chart 200 (FIG. 2) was described in a particular order, it should be understood that certain blocks of flow chart 200 can be performed in a different order. For example, blocks 210 and 212 may occur prior to formation of the source and drain electrodes in block 206.

FIG. 8 illustrates an alternative example HFET 800 that is fabricated with an alternative example process. HFET 800 includes a GaN film 802 and an AlGaN film 804 that form an active layer. A source electrode 812 and a drain electrode 814 are formed on either side of a gate electrode 816. A gate field plate 818 is adjacent and electrically connected to gate electrode 816. The alternative example process is similar to the process described above with respect to flow chart 200 of FIG. 2, except block 204 is modified to in situ deposit a third film 808, during the same processing steps that in situ deposits first film 806 and second film 810. Third film 808 may be used as an etch-stop layer when etching second film 604 as described above in block 204 (FIG. 2). Accordingly, the material and thickness for third film 808 should be selected such that the etch used for etching second film 810 is sufficiently selective to the material of second film 810 over the material of third film 808. In one case, the thickness of the third film may be about 1.5nm to 3nm and may be made from AlN, SiN, Al₂O₃, SiO₂, HfO₂, or other suitable materials.

As shown in FIG. 8, gate electrode 816 ends with or extends to the top surface of third film 808 as originally deposited. However, in practice, gate electrode 816 may continue into third film 808 by some distance that is less than the thickness of third film 808. Alternatively, third film 808 could be entirely removed from the bottom of gate electrode 816 by selective wet or dry etching the exposed portion of third film 808 subsequent to etching second film 810 but prior to depositing the conductive material that forms gate electrode 816. In this case, gate electrode 816 would be in contact with first film 806.

Adding third film 808 as an etch top layer allows for the first and second films to be made of materials with similar etch properties or be made of the same material. For example, in this example process, the same material may be used for both the first and second films because the third film may protect first film 806 when etching second film 810. In one case, first film 806 may be 150A of Al₂O₃, the third film may be 20A of HfO₂, and second film 810 may be 1500A of Al₂O₃. In another case, first film 806 may be 150A of Al₂O₃, the third film may be 20A of AlN, and second film 810 may be 1500A of SiN. Other processes may use different materials and thicknesses.

FIG. 9 illustrates another example HFET 900 manufactured with another example process. HFET 900 includes a GaN film 902 and an AlGaN 904 that form an active layer. A source electrode 910 and a drain electrode 912 are formed on either side of a gate electrode 914. A gate field plate 916 is adjacent and electrically connected to gate electrode 914. A first film 906 forms a gate dielectric film. A second film 908 forms a gate field plate film. The process for manufacturing HFET 900 is similar to the process described above with respect to flow chart 200 of FIG. 2, except that block 206 is modified to create an eyelet having sidewalls that are substantially perpendicular to the surface of second film 908 so as to create gate electrode 914 with more vertical sidewalls. For example, the etch process or photo process may be modified to adjust the slope of the sidewalls.

FIG. 10 illustrates yet another example HFET 1000 manufactured with yet another example process. HFET 1000 includes a GaN film 1002 and an AlGaN film 1004 that form an active layer. A source electrode 1010 and a drain electrode 1012 are formed on either side of a gate electrode 1014. A first film 1006 forms a gate dielectric film. A second film 1008 forms a gate field plate film. The process for manufacturing HFET 1000 is similar to the process described above with respect to flow chart 200 of FIG. 2, except that block 208 is modified to omit an optional gate field plate.

While optional features, such as the third film, the field plate, and sloped sidewalls of the gate electrode, have been described above with respect to specific HFETs and processes, it should be understand that these features can be mixed and matched in any combination.

The above description of illustrated examples of the present invention, including what is described in the Abstract, are not intended to be exhaustive or to be limitations to the precise forms disclosed. While specific embodiments of, and examples for, the invention are described herein for illustrative purposes, various equivalent modifications are possible without departing from the broader spirit and scope of the present invention. Indeed, it is appreciated that the specific examples of thicknesses, materials, processing operations, etc., are provided for explanation purposes, and that other thicknesses, materials, processing operations, etc. may also be employed in other embodiments, examples, and processes in accordance with the teachings of the present invention.

These modifications can be made to examples of the invention in light of the above detailed description. The terms used in the following claims should not be construed to limit the invention to the specific embodiments disclosed in the specification and the claims. Rather, the scope is to be determined entirely by the following claims, which are to be construed in accordance with established doctrines of claim interpretation. The present specification and Figures are accordingly to be regarded as illustrative rather than restrictive.

### Embodiments

Although the present invention is defined in the attached claims, it should be understood that the present invention can also (alternatively) be defined in accordance with the following embodiments:
1. A method for fabricating a field effect transistor (FET), the method comprising:
   depositing, in an in situ atomic layer deposition (ALD) process, a first dielectric film and a second dielectric film on a wafer having a first semiconductor film at a top surface of the wafer, wherein the first dielectric film is deposited over the first semiconductor film, and wherein the second dielectric film is deposited over the first dielectric film;
   etching a first pattern in the second dielectric film to define a location for a gate electrode;
   depositing a conductor over the first pattern; and
   etching a portion of the conductor to define a second pattern overlapping a portion of the first pattern, wherein the second pattern defines a gate electrode.
2. The method of embodiment 1 further comprising:
   forming a source electrode and a drain electrode, wherein the source electrode and the drain electrode are electrically connected to the first semiconductor film, and wherein the source and drain electrodes are on opposite sides of the gate electrode.
3. The method of embodiment 2, wherein the wafer has a second semiconductor film under the first semiconductor film.
4. The method of embodiment 3, wherein the first semiconductor film is AlGaN and the second semiconductor film is GaN.
5. The method of embodiment 4, wherein etching the first pattern exposes the first dielectric film at a bottom of a portion of the first pattern.
6. The method of embodiment 4, wherein the first and second dielectric films have a different etch property from each other.
7. The method of embodiment 4, wherein between the first and second dielectric films, a third film is in situ deposited, and wherein the third film has a different etch property than the second dielectric film.
8. The method of embodiment 7, wherein the third film is an etch-stop for etching the first pattern in the second dielectric film.
9. The method of embodiment 7, wherein etching the first pattern exposes the third film along a bottom portion of the first pattern.
10. The method of embodiment 9, wherein a top surface of the first dielectric film is expose on the bottom portion of the first pattern prior to depositing the conductor over the first pattern.
11. The method of embodiment 7, wherein the first dielectric film is made of Al₂O₃, the second film is made of HfO₂, and the third film is made of Al₂O₃.
12. The method of embodiment 7, wherein the first dielectric film is made of Al₂O₃, the second film is made of AlN, and the third film is made of SiN.
13. The method of embodiment 4, wherein the wafer includes a handle wafer of sapphire, silicon, or silicon carbide.
14. The method of embodiment 4, wherein the second pattern includes a gate field plate on top of the second film.
15. A field effect transistor (FET) comprising:
   a first semiconductor film at a top surface of a substrate;
   a composite film of a first dielectric film and a second dielectric film on top of the first semiconductor film, wherein the composite film has a layer of the second dielectric film on top of a layer of the first dielectric film, and wherein the composite film is an atomic layer deposition (ALD) in situ deposited film;
   a gate electrode defined within the composite film, wherein the gate electrode is insulated from the first semiconductor film by the first dielectric film;
   a source electrode electrically connected to the first semiconductor film on a side of the gate electrode; and
   a drain electrode electrically connected to the first semiconductor film on an opposite side of the gate electrode as the source electrode.
16. The FET of embodiment 15 further comprising;
   a second semiconductor film between the first semiconductor film and the substrate.
17. The FET of embodiment 16, wherein the first semiconductor film is AlGaN and the second semiconductor film is GaN.
18. The FET of embodiment 17, wherein the first dielectric film and the second dielectric films have a different etch property than each other.
19. The FET of embodiment 18, wherein the first dielectric film is made of Al₂O₃ and the second dielectric is made of silicon nitride.
20. The FET of embodiment 17, wherein the gate electrode contacts a top surface of the first dielectric film.
21. The FET of embodiment 17, wherein the gate electrode contacts a top surface of the third film.
22. The FET of embodiment 16, wherein the composite film includes a third film between the layer of the first dielectric film and the layer of the second dielectric film, and wherein the third film and the second dielectric film have a different etch property from each other.
23. The FET of embodiment 22, wherein the first dielectric film and the second dielectric film are made of the same material.
24. The FET of embodiment 22, wherein the first dielectric film and the second dielectricfilm are made of Al₂O₃ and the third film is made of HfO₂.
25. The FET of embodiment 17, wherein the first dielectric film is made of Al₂O₃, the third film is made of AlN, and the second dielectric film is made of SiN.
26. The FET of claim 16, wherein the FET is a heterostructure FET.

## Claims

1. A method for fabricating a field effect transistor (FET), the method comprising:
depositing, in an in situ atomic layer deposition (ALD) process, a first dielectric film and a second dielectric film on a wafer having a first semiconductor film at a top surface of the wafer, wherein the first dielectric film is deposited over the first semiconductor film, and wherein
the second dielectric film is deposited over the first dielectric film;
etching a first pattern in the second dielectric film to define a location for a gate electrode;
depositing a conductor over the first pattern; and
etching a portion of the conductor to define a second pattern overlapping a portion of the first pattern, wherein the second pattern defines a gate electrode.

2. The method of claim 1 further comprising:
forming a source electrode and a drain electrode, wherein the source electrode and the drain electrode are electrically connected to the first semiconductor film, and wherein the source and drain electrodes are on opposite sides of the gate electrode.

3. The method of claim 2, wherein the wafer has a second semiconductor film under the first semiconductor film.

4. The method of claim 3, wherein the first semiconductor film is AlGaN and the second semiconductor film is GaN.

5. The method of claim 4, wherein etching the first pattern exposes the first dielectric film at a bottom of a portion of the first pattern.

6. The method of claim 4, wherein the first and second dielectric films have a different etch property from each other, preferably wherein the the first dielectric film is made of Al₂O₃ and the second dielectric is made of silicon nitride.

7. The method of claim 4, wherein between the first and second dielectric films, a third film is in situ deposited, and wherein the third film has a different etch property than the second dielectric film.

8. The method of claim 7, wherein the third film is an etch-stop for etching the first pattern in the second dielectric film.

9. The method of claim 7, wherein etching the first pattern exposes the third film along a bottom portion of the first pattern.

10. The method of claim 9, wherein a top surface of the first dielectric film is expose on the bottom portion of the first pattern prior to depositing the conductor over the first pattern.

11. The method of claim 7, the first dielectric film and the second dielectric film are made of the same material preferably wherein the first dielectric film is made of Al₂O₃, the third film is made of HfO₂, and the second film is made of Al₂O₃.

12. The method of claim 7, wherein the first dielectric film is made of Al₂O₃, the third film is made of AlN, and the second film is made of SiN.

13. The method of claim 4, wherein the wafer includes a handle wafer of sapphire, silicon, or silicon carbide.

14. The method of claim 4, wherein the second pattern includes a gate field plate on top of the second film.

15. A field effect transistor (FET) comprising:
a first semiconductor film at a top surface of a substrate;
a composite film of a first dielectric film and a second dielectric film on top of the first semiconductor film, wherein the composite film has a layer of the second dielectric film on top of a layer of the first dielectric film,
and wherein the composite film is an atomic layer deposition (ALD) in situ deposited film;
a gate electrode defined within the composite film, wherein the gate electrode is insulated from the first semiconductor film by the first dielectric film;
a source electrode electrically connected to the first semiconductor film on a side of the gate electrode; and
a drain electrode electrically connected to the first semiconductor film on an opposite side of the gate electrode as the source electrode.
